# EUROPEAN PATENT SPECIFICATION

(11) **EP 1 317 073 B1**
(45) Date of publication and mention of the grant of the patent: **12.01.2005**
(21) Application number: 02102634.9
(22) Date of filing: 25.11.2002
(51) Int. Cl.: H04B 1/26, H03J 5/24, H03J 1/00, H04N 5/00

(54) **Tuner arrangement and set top box**
Tuneranordnung und Set-Top-Box
Arrangement des tuners et boîte accessoire de communication

(30) Priority: 29.11.2001 GB 1285535
(43) Date of publication of application: 04.06.2003
(73) Proprietor: Zarlink Semiconductor Limited, Swindon, Wiltshire SN2 2QW (GB)
(72) Inventor: Cowley, Nicholas, Paul, Wroughton, Wiltshire SN4 0RT (GB); Theodore, Aaron, Silver St, Minety (GB)
(74) Representative: Robinson, John Stuart

(56) References cited:
- WO-A-98/32233
- US-A- 6 052 569
- DUCOURANT T ET AL: "A 3 chip GaAs double conversion TV tuner system with 70 dB image rejection" IEEE 1989 MTT-S INTERNATIONAL MICROWAVE SYMPOSIUM DIGEST, vol. 1, - 15 June 1989 (1989-06-15) pages 95-98, XP010085541 Long Beach, CA, USA
- NAIR A N: "Interactive television settop terminal architectures" DIGEST OF PAPERS OF COMPCON (COMPUTER SOCIETY CONFERENCE) 1996 TECHNOLOGIES FOR THE INFORMATION SUPERHIGHWAY. SANTA CLARA, FEB. 25 - 28, 1996, DIGEST OF PAPERS OF THE COMPUTER SOCIETY COMPUTER CONFERENCE COMPCON, LOS ALAMITOS, IEEE COMP. SOC. PRESS, , vol. CONF. 41, 25 February 1996 (1996-02-25), pages 233-238, XP010160900 ISBN: 0-8186-7414-8
- D'LUNA L ET AL: "A dual-channel QAM/QPSK receiver IC with integrated cable set-top box functionality" CUSTOM INTEGRATED CIRCUITS CONFERENCE, 1998. PROCEEDINGS OF THE IEEE 1998 SANTA CLARA, CA, USA 11-14 MAY 1998, NEW YORK, NY, USA,IEEE, US, 11 May 1998 (1998-05-11), pages 351-354, XP010293945 ISBN: 0-7803-4292-5

## Description

The present invention relates to a tuner arrangement and to a set top box including such an arrangement. Such arrangements may, for example, be connected to digital cable networks or to aerials for receiving digital terrestrial broadcast signals.

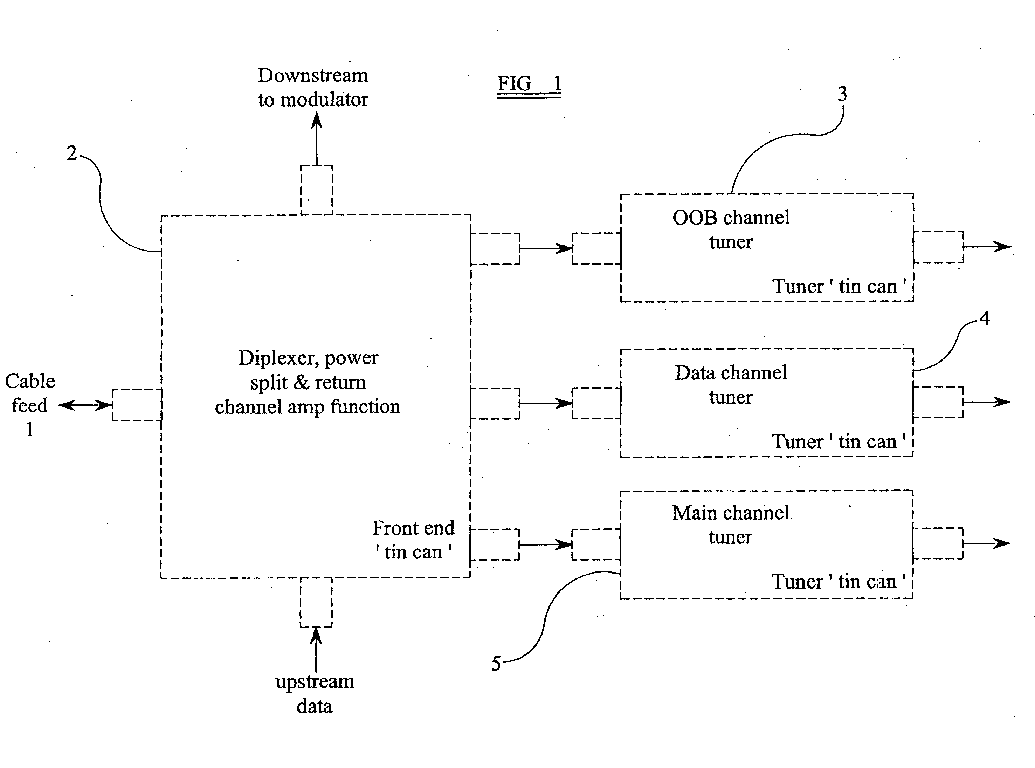

With the increasing number of services being offered through set top box terminals, such as "watch and record" and "parallel digital/analog reception", there is an increasing requirement for multiple radio frequency (RF) interfaces, for example to cable distribution networks. Figure 1 of the accompanying drawings illustrates a known approach to this problem in which a cable feed 1 from a cable distribution network is connected to a diplexer 2. The diplexer 2 isolates upstream and downstream bandwidths and performs a power splitting function so as to supply the broadband signals from the cable feed 1 to several tuners, such as the three tuners 3, 4 and 5 shown in this example.

Each of the modules 2 to 5 shown in Figure 1 is an independent module and is provided in a "tin can" or Faraday cage for screening purposes. The tuners shown in Figure 1 comprise, by way of example, an OOB channel tuner 3, a data channel tuner 4 and a main channel tuner 5. Each of the tuners 3 to 5 converts a selected channel to a predetermined intermediate frequency (IF) output, which may be further amplified and filtered either internally of the tuner or externally. The IF outputs are supplied to the appropriate demodulators (not shown).

This known type of arrangement requires that a power splitting function be performed within the diplexer 2. Also, because the tuners 3 to 5 are independent of each other, functions common to the tuners are multiplicated. Further, there are penalties in the space requirement, cost and power dissipation.

GB 2 216 354 discloses a tuner for selecting a single channel at a time. Several mixers are connected with their inputs and outputs in parallel and are enabled one at a time.

The mixers receive local oscillator signals from a common local oscillator via respective taps in a divider chain. The arrangement is formed in a single integrated circuit.

EP 1 113 573 discloses a single tuner which is capable of receiving two different bands. There are two radio frequency "front ends" for the respective bands and either of these can be switched to a single image reject mixer. Similarly, the local oscillator has a small divider chain and band-switching is performed synchronously with selecting the front ends so as to achieve the correct tuning range. This arrangement is formed on a single integrated circuit.

EP 1 041 724 discloses a modular arrangement formed in a single integrated circuit (IC) to allow different configurations to be provided by a common IC in a mobile phone base station receiver. The IC is configured to act as a receiver channel and a diversity channel. A single radio frequency input is divided to separate mixers in the two channels. However, the mixers are supplied by a single common local oscillator arrangement.

WO 00/62532 discloses a dual conversion tuner for converting a selected input channel to quadrature baseband signals. Up conversion is followed by baseband down conversion and low pass filtering in the I and Q channels. The arrangement is formed as a single integrated circuit. Figure 6 of this document discloses a band-splitting arrangement in which the input spectrum is divided into different sub-bands which are fed to respective mixers. The outputs of the mixers are connected in parallel to a single IF filter. Figure 7 of this document extends this arrangement to having individual IF filters in the mixer outputs and these IF filters have different passbands. However, the individual channels are connected together into a single IF channel at or before the single common downconverter. Thus, this arrangement can only select a single channel at a time for reception.

US 6 052 569 discloses a car radio for receiving information, such as traffic or weather information, without interrupting normal reception, for example of an entertainment channel. The arrangement makes use of two completely independent tuners. A first tuner receives either an FM channel or AM channel whereas the second tuner receives an FM channel or a US weather signal frequency modulated in the band 162.4-162.55Mhz. The whole arrangement and each individual tuner are formed as a plurality of integrated circuits and "discrete" modules. Figure 1a of this document discloses two tuner paths which share a common local oscillator and are not both capable of simultaneously receiving independent selectable channels.

US 5 323 064 discloses a DBS (direct broadcast by satellite) downconverter in the form of a single microwave integrated circuit. The arrangement has two channels with , respective mixers supplied by a common local oscillator arrangement such that the channels are tuned to select the same frequency channel. However, the channels are connected to a satellite aerial such that one down-converts the vertically polarised signal whereas the other down-converts the horizontally polarised signal in a system where horizontal and vertical polarization is used to double the number of channels which can be handled in a given band width.

WO98/32233 provides for a multi-channel receiver in which two tuners may be merged into a single module. Various approaches to reduce mutual interference between tuners are considered.

The article "A 3 Chip GaAs Double Conversion TV Tuner System with 70dB Image Rejection", Ducourant et al, 1989 IEEE MTT-S Digest, pages 95-98, describes a doble conversion architecture tuner implemented using 3 separate chips.

The article "Interactive Television Settop Terminal Architectures", Ajith N. Nair, Proceedings of COMPCON '96, pages 233-238, provides a general discussion of cable television delivery and reception systems, including a discussion of typical settop terminal architectures.

The article "A Dual-Channel QAM/QPSK Receiver IC with Integrated Cable Set-Top Box Functionality", Lionel D'Luna et al, IEEE 1998 Custom Integrated Circuits Conference, pages 351-354, describes a single chip architecture for recovering QAM in-band and QPSK out of band channels from a received signal.

According to a first aspect of the invention, there is provided a tuner arrangement comprising a plurality of tuners and a common radio frequency input terminal for supplying an input radio frequency signal to at least some of the tuners, wherein the at least some tuners are arranged to operate simultaneously: to select independently of each other respective desired channels for reception; to convert the desired channels to respective intermediate frequency signals; and to supply the respective intermediate frequency signals to outputs of the at least some tuners characterised in that the arrangement comprises a buffer (11) between the common input terminal (10) and the at least some tuners (12, 13), and in that the arrangement is formed as a single integrated circuit.

The at least some tuners may be substantially identical to each other.

The arrangement may comprise input data bus terminals connected to a data bus interface which is common to the at least some tuners.

The buffer may comprise a low noise amplifier. The arrangement may comprise a filtering arrangement for dividing the output signal of the buffer into a plurality of frequency bands and a switching arrangement for connecting each of the at least some tuners to receive the frequency band containing the selected channel thereof.

Each of the at least some tuners may comprise an input variable gain circuit. The variable gain circuits may have gain control inputs connected to respective automatic gain control terminals. Each variable gain circuit may comprise a variable attenuator. Each variable gain circuit may comprise a low noise amplifier.

Each of the at least some tuners may comprise an input filter. Each input filter may have a fixed frequency response. As an alternative, each input filter may have a switched frequency response. As a further alternative, each input filter may be a tracking filter.

Each of the at least some tuners may comprise an upconverter and a downconverter. The upconverter may be tunable. The upconverters may be arranged to convert the selected channels to different intermediate frequencies. The downconverters may have local oscillators arranged to be tuned to different frequencies. As an alternative, the downconverters may comprise a single local oscillator common to the at least some tuners. Each of the downconverters may comprise an image reject mixer. The arrangement may comprise first and second terminals for an external intermediate frequency filter connected to the output of the upconverter and the input of the downconverter, respectively.

The at least some tuners may comprise a plurality of frequency synthesisers and a common reference oscillator.

According to a second aspect of the invention, there is provided a set top box comprising an arrangement according to the first aspect of the invention.

At least one of the at least some tuners may comprise a plurality of intermediate frequency output terminals connected to an output selecting switching arrangement.

The set top box may be provided for connection to a cable distribution network.

It is thus possible to provide a tuner arrangement which is capable of independently receiving several channels simultaneously from a single RF input so that, for example, external power splitting is not needed. Such an arrangement can be formed on a single integrated circuit so that space and power requirements can be reduced. For example, it is not necessary to duplicate common functionality. Separate housing for individual tuners can be avoided and substantial savings in cost and power dissipation are possible.

The invention will be further described, by way of example, with reference to the accompanying drawings, in which:
Figure 1 is a block schematic diagram of a known type of multiple tuner arrangement;
Figure 2 is a block circuit diagram of a tuner arrangement constituting a first embodiment of the invention; and
Figure 3 is a block circuit diagram of a tuner arrangement constituting a second embodiment of the invention.

Like reference numerals refer to like parts throughout the drawings.

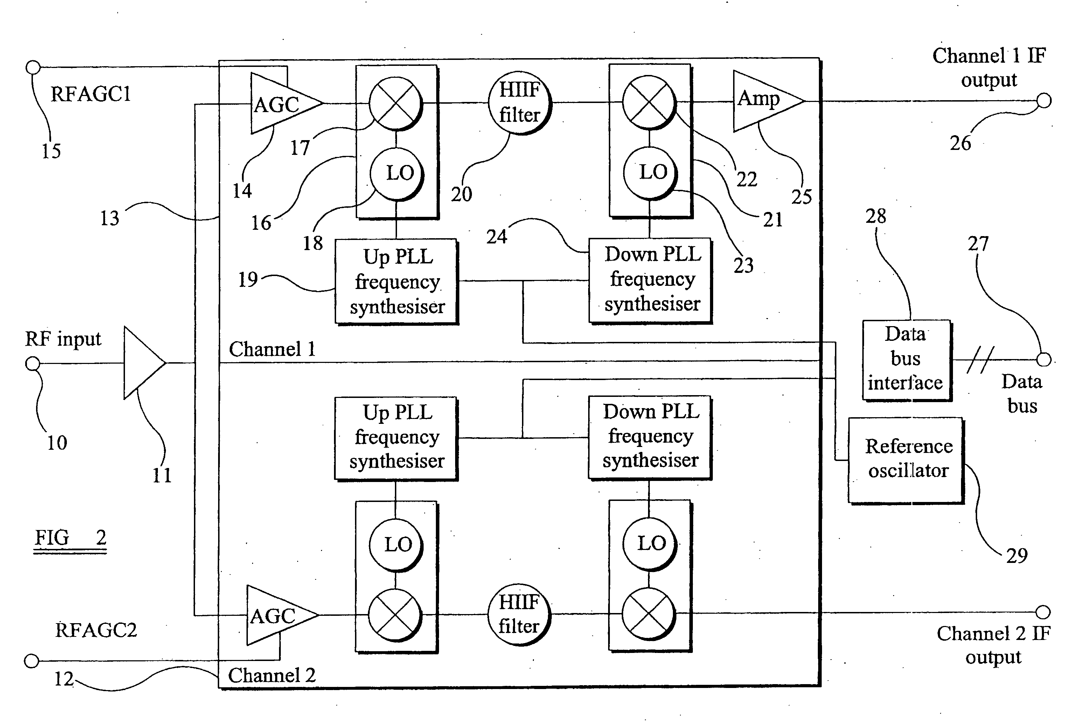

The tuner arrangement shown in Figure 2 comprises an RF input 10 connected to an input buffer 11 in the form of a low noise amplifier (LNA) which presents a controlled input impedance at the input 10. The input 10 receives broadband RF signals, for example from a cable distribution network via a diplexer of the type shown in Figure 1 so that the buffer 11 is required to have a dynamic range which is compatible with signal-to-noise and signal-to-intermodulation requirements.

The output of the buffer 11 is connected to a plurality of channels. In the example shown in Figure 2, two channels ("channel 1" and "channel 2") are provided and are indicated at 12 and 13. The channels 12 and 13 are, in the embodiment shown in Figure 2, identical to each other so that only channel 1 (13) will be described in detail.

The output of the buffer 11 is connected to the input of an automatic gain control (AGC) circuit 14. The circuit 14 has a gain control input connected to a terminal 15 of a monolithic integrated circuit in which the tuner arrangement is formed. The circuit 14 may comprise a variable attenuator, a variable gain low noise amplifier or a combination of a variable attenuator and a low noise amplifier. The gain of the circuit 14 is controlled externally by means of a gain control signal RF AGC1, for example based on signal level measurement downstream of the circuit 14 or on the performance of a demodulator to which the channel is connected. The AGC circuit 14 is generally controlled so as to maintain the signal level supplied to the following stages at an optimum level for a desired signal-to-(noise + intermodulation) performance.

The output of the circuit 14 is supplied to a first frequency changer 16 in the form of an upconverter for converting a desired channel to a high first intermediate frequency (IF), such as 1.22GHz. The converter comprises a mixer 17 and a local oscillator 18 controlled by a phase locked loop (PLL) frequency synthesiser 19. The output of the mixer 17 at the high first intermediate frequency is connected to an IF filter 20 of bandpass characteristic having a passband generally centred on the first intermediate frequency and having a bandwidth for passing the desired or selected channel and several adjacent channels while substantially rejecting all other channels converted by the upconverter 16. Although the filter 20 is shown on the integrated circuit containing the tuner arrangement of Figure 2, it may be provided externally of the integrated circuit, in which case the appropriate integrated circuit terminals are provided for connection to the filter.

The output of the filter 20 is supplied to a second frequency changer 21 comprising a downconverter which converts the selected channel to a desired output intermediate frequency, such as 44MHz. The downconverter 21 also comprises a mixer 22 and a local oscillator (LO) 23 controlled by a further PLL frequency synthesiser 24. The mixer 22 is preferably of the image reject type and its output is supplied to an IF amplifier 25 which amplifies the downconverted signal and supplies this as the channel 1 IF output at an output terminal 26.

The integrated circuit comprises a data bus input terminal arrangement 27 for receiving control data for controlling operation of the frequency synthesisers 19 and 24 of all of the channels. The input arrangement 27, for example comprising one serial input terminal or a plurality of parallel input terminals, is connected to a data bus interface 28 which is common to all of the channels 12, 13 and which supplies the appropriate control signals to the frequency synthesisers 19, 24 of all of the channels.

The tuner arrangement comprises a reference oscillator 29 which is also common to all of the channels and which supplies a stable frequency reference signal to all of the synthesisers 19, 24 of all of the channels.

In use, each of the tuner channels operates substantially independently of each of the other channels. In particular, each tuner channel is arranged to convert any selected channel within the broadband signal at the input 10 to the desired output intermediate frequency at its output, such as 26. When a user selects a channel for reception, the appropriate tuning data are supplied via the input terminal arrangement 27 and the data bus interface 28 to the frequency synthesisers 19 and 24 of the appropriate channel. The local oscillators 18 and 23 are controlled to produce the local oscillator signal frequencies such that the selected channel is converted in frequency by the upconverter 16 to the first high intermediate frequency and is then converted by the downconverter 21 to the output intermediate frequency.

Although all of the tuner channels may have filters 20 of the same characteristic and, in particular, with the same centre frequency, different channels may have filters of different centre frequencies so that the different channels have different first intermediate frequencies. Alternatively, if the passband characteristics of the filters 20 are appropriate, for example sufficiently wide, the same types of filters may be used in all of the channels but the selected reception channels may be converted to different first intermediate frequencies within the filter passbands. Such a technique reduces the crosstalk between selected channels in different tuner channels. Also, the local oscillator frequencies of the downconverters in the different channels may be different from each other. For example, where different first intermediate frequencies are used in the different channels but the same output intermediate frequency is used for all channels, the local oscillator frequencies of the downconverters in the different channels will be required to be different so as to produce the correct output intermediate frequencies. Where the same first intermediate frequencies are used, different output intermediate frequencies permit different local oscillator frequencies to be used in the different tuner channels. Such an arrangement reduces beating between the downconverter local oscillators.

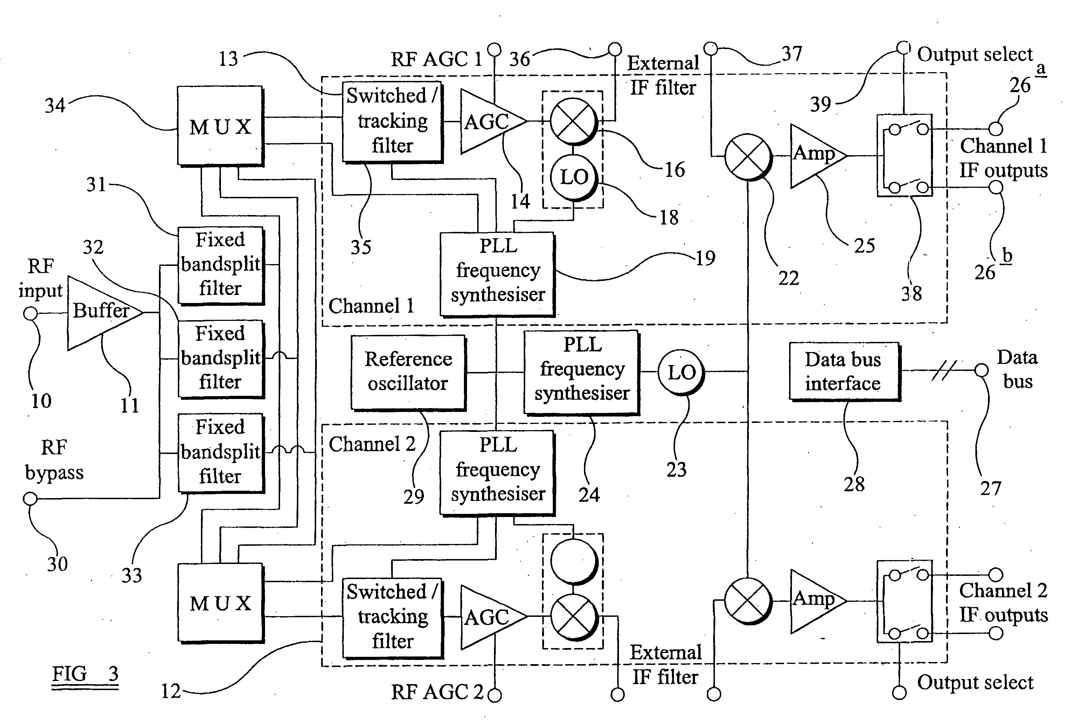

The tuning arrangement shown in Figure 3 differs from that shown in Figure 2 in various ways as described hereinafter. This embodiment includes various features which may be provided but which are optional so that different embodiments would comprise different combinations of these features.

The buffer 11 shown in Figure 3 may comprise an LNA as described with reference to Figure 2 or may comprise a unity gain buffer. The output of the buffer 11 is connected to a terminal 30 of the integrated circuit for providing an RF bypass output for passing the RF input signals substantially unchanged to other circuits without altering the loading, for example on a cable distribution network connected to the RF input 10. The output of the buffer 11 is also connected to the inputs of three bandsplitting filters 31, 32 and 33. The filters 31-33 have fixed frequency response characteristics and divide the broadband input signal into three different sub-bands which are contiguous with or overlap each other. All three of the filters 31-33 may be bandpass filters. Alternatively, the filters may comprise a highpass filter, a lowpass filter and a bandpass filter. Also, any number of such filters may be provided to divide the broadband signal into any desired number of sub-bands.

The outputs of the filters 31-33 are supplied to multiplexers (MUX) such as 34, each associated with a respective tuner channel. The multiplexer 34 is associated with channel 1 (13) and its output is connected to a filter 35, whose output is connected to the AGC circuit 14. The filter 35 may be a switched response filter which can be controlled to supply signals in different sub-bands of the input band to the filter. Alternatively, the filter 35 may be a tracking filter which tracks the frequency of the local oscillator 18 so as to be substantially centred on the frequency of the currently selected channel.

The multiplexer 34 and the filter 35 are controlled by the synthesiser 19 in accordance with the currently selected channel. In particular, the synthesiser 19 ensures that the multiplexer 34 selects the sub-band containing the frequency of the selected channel. Similarly, the filter 35 is controlled so that the selected channel is within the sub-band which it passes to the circuit 14. Such an arrangement reduces the signal energy supplied to the following stages while passing the selected channel so that, for example, the intermodulation performance of the subsequent stages can be relaxed. For example, in the case of the frequency changer 16, the intermodulation performance generally improves with increasing power dissipation so that, by reducing the required intermodulation performance, the power dissipation may be reduced. The mixer 17 and other stages may be provided with arrangements which allow the stage power dissipation to be controlled or varied, for example by selection by a user or by an automatic control arrangement based on the performance actually being achieved during operation.

As mentioned hereinbefore, the first IF filter may be provided externally of the integrated circuit and Figure 3 illustrates the provision of integrated circuit terminals 36 and 37 for connection to an external filter.

The embodiment of Figure 3 further differs from that shown in Figure 2 in that the individual downconverter local oscillators 23 and frequency synthesisers 24 are replaced by a single local oscillator and synthesiser (which receives the reference signal from the common reference oscillator 29) with the local oscillator signal being supplied to the downconverter mixers 22 of all of the tuner channels. Such an arrangement may be used, for example, where all of the first intermediate frequencies are equal to each other and where all of the output intermediate frequencies are equal to each other. Such an arrangement reduces the required area of the integrated circuit and the power dissipation thereof.

The output of the amplifier 25 of each tuner channel is connected to an electronic switching arrangement 38 which is controlled by an output select terminal 39. The arrangement 38 comprises a plurality of (in this case two) switches which allow different IF outputs 26a, 26b to be selected. Thus, each tuner channel may be switched to different following stages, for example to allow reception of signals having different filtering and/or demodulation requirements.

Various modifications may be made within the scope of the invention. For example, low noise amplifiers may be provided at the outputs of each of the filters 31-33. Also, further IF amplification may be provided within any of the tuner channels. Further, any of the local oscillators may be of the band-switched type.

## Claims

1. A tuner arrangement comprising a plurality of tuners (12, 13) and a common radio frequency input terminal (10) for supplying an input radio frequency signal to at least some of the tuners (12, 13), wherein the at least some tuners (12, 13) are arranged to operate simultaneously: to select independently of each other respective desired channels for reception; to convert the desired channels to respective intermediate frequency signals; and to supply the respective intermediate frequency signals to outputs (26, 26a, 26b) of the at least some tuners (12, 13),
**characterised in that**
the arrangement comprises a buffer (11) between the common input terminal (10) and the at least some tuners (12, 13), and **in that** the arrangement is formed as a single integrated circuit.

2. An arrangement as claimed in claim 1, **characterised in that** the at least some tuners (12, 13) are substantially identical to each other.

3. An arrangement as claimed in claim 1 or 2, **characterised by** comprising input data bus terminals (27) connected to a data bus interface (28) which is common to the at least some tuners (12, 13).

4. An arrangement as claimed in any one of claims 1 to 3, **characterised in that** the buffer (11) comprises a low noise amplifier.

5. An arrangement as claimed in any one of the preceding claims, **characterised by** comprising a filtering arrangement (31-33) for dividing the output signal of the buffer (11) into a plurality of frequency bands and a switching arrangement (34) for connecting each of the at least some tuners (12, 13) to receive the frequency band containing the selected channel thereof.

6. An arrangement as claimed in any one of the preceding claims, **characterised in that** each of the at least some tuners (12, 13) comprises an input variable gain circuit (14).

7. An arrangement as claimed in claim 6, **characterised in that** the variable gain circuits (14) have gain control inputs connected to respective automatic gain control terminals.

8. An arrangement as claimed in claim 6 or 7, **characterised in that** each variable gain circuit (14) comprises a variable attenuator.

9. An arrangement as claimed in any one of claims 6 to 8, **characterised in that** each variable gain circuit (14) comprises a low noise amplifier.

10. An arrangement as claimed in any one of the preceding claims, **characterised in that** each of the at least some tuners (12, 13) comprises an input filter (35).

11. An arrangement as claimed in claim 10, **characterised in that** each input filter (35) has a fixed frequency response.

12. An arrangement as claimed in claim 10, **characterised in that** each input filter (35) has a switched frequency response.

13. An arrangement as claimed in claim 10, **characterised in that** each input filter (35) is a tracking filter.

14. An arrangement as claimed in any one of the preceding claims, **characterised in that** each of the at least some tuners (12, 13) comprises an upconverter (16) and a downconverter (21-23).

15. An arrangement as claimed in claim 14, **characterised in that** the upconverters (16) are tunable.

16. An arrangement as claimed in claim 14 or 15, **characterised in that** the upconverters (16) are arranged to convert the selected channels to different intermediate frequencies.

17. An arrangement as claimed in claim 16, **characterised in that** the downconverters (21) have local oscillators (23) arranged to be tuned to different frequencies.

18. An arrangement as claimed in claim 14 or 15, **characterised in that** the downconverters comprise a single local oscillator (23) common to the at least some tuners (12, 13).

19. An arrangement as claimed in any one of claims 14 to 18, **characterised in that** each of the downconverters comprises an image reject mixer (22).

20. An arrangement as claimed in any one of claims 14 to 19, **characterised by** comprising first and second terminals (36, 37) for an external intermediate frequency filter (20) connected to the output of the upconverter (16) and the input of the downconverter (21-23), respectively.

21. An arrangement as claimed in any one of the preceding claims, **characterised in that** the at least some tuners (12, 13) comprise a plurality of frequency synthesisers (19, 24) and a common reference oscillator (29).

22. An arrangement as claimed in any one of the preceding claims, **characterised in that** at least one of the at least some tuners (12, 13) comprises a plurality of intermediate frequency output terminals (26a, 26b) connected to an output selecting switching arrangement (38).

23. A set top box comprising an arrangement as claimed in any one of the preceding claims.

24. A set top box as claimed in claim 23, for connection to a cable distribution network.

## Patentansprüche

1. Tuneranordnung mit einer Vielzahl von Tunern (12, 13) und einem gemeinsamen Funkfrequenz-Eingangsanschluß (10) zum Übergeben eines Funkfrequenz-Eingangssignals an mindestens einige der Tuner (12, 13), wobei die mindestens einigen Tuner (12, 13) angeordnet sind, um gleichzeitig folgendes durchzuführen: unabhängig voneinander jeweilige gewünschte Kanäle zum Empfang auswählen, die gewünschten Kanäle in jeweilige Zwischenfrequenzsignale umsetzen und die jeweiligen Zwischenfrequenzsignale an Ausgänge (26, 26a, 26b) der mindestens einigen Tuner (12, 13) übergeben;
**dadurch gekennzeichnet, daß**
die Anordnung einen Puffer (11) zwischen dem gemeinsamen Eingangsanschluß (10) und den mindestens einigen Tunern (12, 13) umfaßt und daß die Anordnung als ein einziger integrierter Schaltkreis ausgebildet ist.

2. Anordnung nach Anspruch 1, **dadurch gekennzeichnet, daß** die mindestens einigen Tuner (12, 13) im wesentlichen identisch miteinander sind.

3. Anordnung nach Anspruch 1 oder 2, **dadurch gekennzeichnet, daß** die Anordnung Eingangsdaten-Busanschlüsse (27) umfaßt, die mit einer Datenbus-Schnittstelle (28) verbunden sind, die die mindestens einigen Tuner (12, 13) gemeinsam haben.

4. Anordnung nach einem der Ansprüche 1 bis 3, **dadurch gekennzeichnet, daß** der Puffer (11) einen rauscharmen Verstärker umfaßt.

5. Anordnung nach einem der vorhergehenden Ansprüche, **dadurch gekennzeichnet, daß** die Anordnung umfaßt: eine Filteranordnung (31-33) zum Aufteilen des Ausgangssignals des Puffers (11) in eine Vielzahl von Frequenzbändern und eine Schaltungsanordnung (34) zum Verbinden jedes der mindestens einigen Tuner (12, 13), um das Frequenzband zu empfangen, das seinen ausgewählten Kanal enthält.

6. Anordnung nach einem der vorhergehenden Ansprüche, **dadurch gekennzeichnet, daß** jeder der mindestens einigen Tuner (12, 13) eine regelbare Eingangsverstärkungsschaltung (14) umfaßt.

7. Anordnung nach Anspruch 6, **dadurch gekennzeichnet, daß** die regelbaren Verstärkungsschaltungen (14) Verstärkungsregelungseingänge haben, die mit entsprechenden Anschlüssen zur automatischen Verstärkungsregelung verbunden sind.

8. Anordnung nach Anspruch 6 oder 7, **dadurch gekennzeichnet, daß** jede regelbare Verstärkungsschaltung (14) ein regelbares Dämpfungsglied umfaßt.

9. Anordnung nach einem der Ansprüche 6 bis 8, **dadurch gekennzeichnet, daß** jede regelbare Verstärkungsschaltung (14) einen rauscharmen Verstärker umfaßt.

10. Anordnung nach einem der vorhergehenden Ansprüche, **dadurch gekennzeichnet, daß** jeder der mindestens einigen Tuner (12, 13) ein Eingangsfilter (35) umfaßt.

11. Anordnung nach Anspruch 10, **dadurch gekennzeichnet, daß** jedes Eingangsfilter (35) einen festen Frequenzgang hat.

12. Anordnung nach Anspruch 10, **dadurch gekennzeichnet, daß** jedes Eingangsfilter (35) einen geschalteten Frequenzgang hat.

13. Anordnung nach Anspruch 10, **dadurch gekennzeichnet, daß** jedes Eingangsfilter (35) ein Nachlauffilter ist.

14. Anordnung nach einem der vorhergehenden Ansprüche, **dadurch gekennzeichnet, daß** jeder der mindestens einigen Tuner einen Aufwärtsumsetzer (16) und einen Abwärtsumsetzer (21-23) umfaßt.

15. Anordnung nach Anspruch 14, **dadurch gekennzeichnet, daß** die Aufwärtsumsetzer (16) durchstimmbar sind.

16. Anordnung nach Anspruch 14 oder 15, **dadurch gekennzeichnet, daß** die Aufwärtsumsetzer (16) angeordnet sind, um die ausgewählten Kanäle in unterschiedliche Zwischenfrequenzen umzusetzen.

17. Anordnung nach Anspruch 16, **dadurch gekennzeichnet, daß** die Abwärtsumsetzer (21) lokale Oszillatoren (23) haben, die angeordnet sind, um auf verschiedene Frequenzen abgestimmt zu werden.

18. Anordnung nach Anspruch 14 oder 15, **dadurch gekennzeichnet, daß** die Abwärtsumsetzer einen einzigen lokalen Oszillator (23) umfassen, den die mindestens einigen Tuner (12, 13) gemeinsam haben.

19. Anordnung nach einem der Ansprüche 14 bis 18, **dadurch gekennzeichnet, daß** jeder der Abwärtsumsetzer einen Image-Reject-Mixer (22) umfaßt.

20. Anordnung nach einem der Ansprüche 14 bis 19, **dadurch gekennzeichnet, daß** die Anordnung erste und zweite Anschlüsse (36, 37) für ein externes Zwischenfrequenzfilter (20) umfassen, das mit dem Ausgang des Aufwärtsumsetzers (16) beziehungsweise dem Eingang des Abwärtsumsetzers (21-23) verbunden ist.

21. Anordnung nach einem der vorhergehenden Ansprüche, **dadurch gekennzeichnet, daß** die mindestens einigen Tuner (12, 13) eine Vielzahl von Frequenzsynthesizern (19, 24) und einen gemeinsamen Referenzoszillator (29) umfassen.

22. Anordnung nach einem der vorhergehenden Ansprüche, **dadurch gekennzeichnet, daß** mindestens einer der mindestens einigen Tuner (12, 13) eine Vielzahl von Zwischenfrequenz-Ausgangsanschlüssen (26a, 26b) umfaßt, die mit einer Ausgangsauswahl-Schaltanordnung (38) verbunden sind.

23. Set-Top-Box mit einer Anordnung nach einem der vorhergehenden Ansprüche.

24. Set-Top-Box nach Anspruch 23, zur Verbindung mit einem Kabelverteilungsnetzwerk.

## Revendications

1. Agencement de tuners comprenant une pluralité de tuners (12, 13) et une borne d'entrée de fréquence radio commune (10) pour appliquer un signal de fréquence radio d'entrée sur au moins certains des tuners (12, 13), dans lequel les au moins certains des tuners (12, 13) sont agencés pour fonctionner de façon simultanée, pour sélectionner de manière indépendante les uns des autres des canaux souhaités respectifs pour la réception, pour convertir les canaux souhaités selon des signaux de fréquence intermédiaire respectifs et pour appliquer les signaux de fréquence intermédiaire respectifs sur des sorties (26, 26a, 26b) des au moins certains des tuners (12, 13),
**caractérisé en ce que**:
l'agencement comprend un tampon (11) entre la borne d'entrée commun (10) et les au moins certains des tuners (12, 13) et **en ce que** l'agencement est formé en tant que unique circuit intégré.

2. Agencement selon la revendication 1, **caractérisé en ce que** les au moins certains des tuners (12, 13) sont sensiblement identiques les uns aux autres.

3. Agencement selon la revendication 1 ou 2, **caractérisé en ce qu'**il comprend des bornes de bus de données d'entrée (27) qui sont connectées à une interface de bus de données (28) qui est commune aux au moins certains des tuners (12, 13).

4. Agencement selon l'une quelconque des revendications 1 à 3, **caractérisé en ce que** le tampon (11) comprend un amplificateur à faible bruit.

5. Agencement selon l'une quelconque des revendications précédentes, **caractérisé en ce qu'**il comprend un agencement de filtrage (31-33) pour diviser le signal de sortie du tampon (11) selon une pluralité de bandes de fréquences et un agencement de commutation (34) pour connecter chacun des au moins certains des tuners (12, 13) pour recevoir la bande de fréquences qui contient le canal sélectionné afférent.

6. Agencement selon l'une quelconque des revendications précédentes, **caractérisé en ce que** chacun des au moins certains des tuners (12, 13) comprend un circuit de gain variable d'entrée (14).

7. Agencement selon la revendication 6, **caractérisé en ce que** les circuits de gain variable (14) comportent des entrées de commande de gain qui sont connectées à des bornes de commande automatique de gain respectives.

8. Agencement selon la revendication 6 ou 7, **caractérisé en ce que** chaque circuit de gain variable (14) comprend un atténuateur variable.

9. Agencement selon l'une quelconque des revendications 6 à 8, **caractérisé en ce que** chaque circuit de gain variable (14) comprend un amplificateur à faible bruit.

10. Agencement selon l'une quelconque des revendications précédentes, **caractérisé en ce que** chacun des au moins certains des tuners (12, 13) comprend un filtre d'entrée (35).

11. Agencement selon la revendication 10, **caractérisé en ce que** chaque filtre d'entrée (35) présente une réponse de fréquence fixe.

12. Agencement selon la revendication 10, **caractérisé en ce que** chaque filtre d'entrée (35) présente une réponse de fréquence commutée.

13. Agencement selon la revendication 10, **caractérisé en ce que** chaque filtre d'entrée (35) est un filtre de suivi.

14. Agencement selon l'une quelconque des revendications précédentes, **caractérisé en ce que** chacun des au moins certains des tuners (12, 13) comprend un convertisseur élévateur (16) et un convertisseur abaisseur (21-23).

15. Agencement selon la revendication 14, **caractérisé en ce que** les convertisseurs élévateurs (16) sont accordables.

16. Agencement selon la revendication 14 ou 15, **caractérisé en ce que** les convertisseurs élévateurs (16) sont agencés pour convertir les canaux sélectionnés selon des fréquences intermédiaires différentes.

17. Agencement selon la revendication 16, **caractérisé en ce que** les convertisseurs abaisseurs (21) comportent des oscillateurs locaux (23) qui sont agencés pour être accordés sur des fréquences différentes.

18. Agencement selon la revendication 14 ou 15, **caractérisé en ce que** les convertisseurs abaisseurs comprennent un unique oscillateur local (23) qui est commun pour les au moins certains des tuners (12, 13).

19. Agencement selon l'une quelconque des revendications 14 à 18, **caractérisé en ce que** chacun des convertisseurs abaisseurs comprend un mélangeur de réjection d'image (22).

20. Agencement selon l'une quelconque des revendications 14 à 19, **caractérisé en ce qu'**il comprend des première et seconde bornes (36, 37) pour un filtre de fréquence intermédiaire externe (20) qui est connecté à la sortie du convertisseur élévateur (16) et à l'entrée du convertisseur abaisseur (21-23), de façon respective.

21. Agencement selon l'une quelconque des revendications précédentes, **caractérisé en ce que** les au moins certains des tuners (12, 13) comprennent une pluralité de synthétiseurs de fréquence (19, 24) et un oscillateur de référence commun (29).

22. Agencement selon l'une quelconque des revendications précédentes, **caractérisé en ce que** au moins l'un des au moins certains des tuners (12, 13) comprend une pluralité de bornes de sortie de fréquence intermédiaire (26a, 26b) qui sont connectées à un agencement de commutation de sélection de sortie (38).

23. Boîte accessoire comprenant un agencement selon l'une quelconque des revendications précédentes.

24. Boîte accessoire selon la revendication 23, pour une connexion sur un réseau de distribution par câble.
